Europäisches Patentamt

(19) European Patent Office

Office européen des brevets

(11) EP 0 905 747 B1

(12) **EUROPEAN PATENT SPECIFICATION**

(45) Date of publication and mention
of the grant of the patent:
**30.11.2005 Bulletin 2005/48**

(51) Int Cl.⁷: $H01L\ 21/00$

(21) Application number: **98870200.7**

(22) Date of filing: **22.09.1998**

(54) **Method and apparatus for removing a liquid from a surface of a rotating substrate**

Verfahren und Vorrichtung zum Entfernen von einer Flüssigkeit von der Oberfläche eines rotierenden Substrats

Méthode et dispositif pour enlever un liquide de la surface d'un substrat tournant

(84) Designated Contracting States:
**AT BE CH DE ES FR GB IE IT LI NL SE**

(30) Priority: **24.09.1997 US 59929 P**
**20.03.1998 EP 98870056**
**27.03.1998 US 79688 P**
**06.05.1998 US 84651 P**

(43) Date of publication of application:
**31.03.1999 Bulletin 1999/13**

(73) Proprietor: **INTERUNIVERSITAIR**
**MICRO-ELEKTRONICA CENTRUM VZW**
**3001 Heverlee (BE)**

(72) Inventors:
• **Mertens, Paul**
**3150 Haacht (BE)**
• **Meuris, Mark**
**3140 Keerbergen (BE)**
• **Heyns, Marc**
**3210 Linden (BE)**

(74) Representative: **Van Malderen, Joelle et al**
**pronovem - Office Van Malderen**
**Avenue Josse Goffin 158**
**1082 Bruxelles (BE)**

(56) References cited:
**EP-A- 0 905 746         US-A- 4 027 686**
**US-A- 5 271 774**

• **PATENT ABSTRACTS OF JAPAN vol. 095, no. 011, 26 December 1995 & JP 07 211686 A (SONY CORP), 11 August 1995**
• **PATENT ABSTRACTS OF JAPAN vol. 097, no. 010, 31 October 1997 & JP 09 162159 A (DAINIPPON SCREEN MFG CO LTD), 20 June 1997**

## Description

FIELD OF THE INVENTION

The present invention according to claim 1 is related to a method of removing a liquid from a rotating substrate. This liquid can be any wet processing liquid as e.g. a wet etching liquid or a cleaning liquid. It can also be a rinsing liquid. The invention is applicable for a number of wet processing steps which are frequently used in the fabrication process of integrated circuits or liquid crystal displays.

BACKGROUND OF THE INVENTION

The complete and efficient removal of a liquid from a surface of a substrate is a multiply repeated step in e.g. the fabrication process of integrated circuits. Such a step can be performed after a wet etching step or a wet cleaning step or a wet rinsing step or any other step used in said fabrication process wherein said substrate is treated or exposed or immersed in a liquid. Said substrate can be a semiconductor wafer or a part thereof or a glass slice or any other slice of an insulating or conductive material.

The manufacturing of integrated circuits evolves towards processing of each substrate individually rather than in batches of several substrates. In state of the art IC manufacturing, most processing steps as e.g. implantation steps, deposition steps are already performed in a single substrate mode. On the other hand, wet processing steps such as e.g. cleaning steps and subsequent liquid removal steps are typically performed in a batch mode because of lack of appropriate alternatives. Therefore, differences in waiting times are created for each individual substrate between a wet processing step, performed in a batch mode and another processing step, performed in a single substrate mode. Such variability is undesirable with regard to process control. Moreover this mixed batch and single substrate processing increases the cycle time, which is also undesirable. Therefore, there is a general interest in the development of competitive single substrate wet processing steps. Particularly, one of the major challenges regarding single wafer wet processing is a method for removing a liquid from both sides of a substrate. There are two major requirements to be fulfilled for such a method. At first the method should work sufficiently fast. Knowing that in state of the art production lines a substrate is processed typically every 2 to 3 minutes, ideally, in order to avoid equipment duplication, the process step and the liquid removal step should be completed in about such a time frame. Another requirement is related to the preferred substrate orientation. State of the art processing equipment and transportation tools are developed to handle substrates in a horizontal position. Therefore in order to avoid additional substrate handling it would be desirable to perform the wet processing steps using horizontally positioned substrates.

In the European Patent EP 0 385 536 B1, a method is disclosed of drying substrates after treatment in a liquid by pulling said substrate slowly out of said liquid. However, this known method, which is based on the Marangoni principle, requires that the substrates are pulled out of the liquid in an upright position, i.e. a surface of said substrate is about perpendicular to the surface of the liquid bath as can be seen in figures 1 to 6 of the European Patent EP 0 385 536 B1. This handling is incompatible with the majority of the other process steps where the equipment and transportation tools are developed to handle horizontal positioned substrates.

In the United States Patent US 5660642 a liquid removal technique is disclosed wherein a liquid film present on a surface of a substrate can be removed by applying rinsewater together with a surface tension reducing vapor. Particularly, a disadvantage is that regardless of the precise nature of the liquid, during the liquid removal process always rinsewater is supplied. Furthermore, the surface tension reducing vapor is passively applied, e.g. by natural evaporation, which makes it difficult to locally, i.e. at moving zone, have a good and efficient control on the vapor supply or to direct the vapor. Moreover US 5660642 does not disclose how to remove a liquid film substantially simultaneously from two opposite surfaces, i.e. top and bottomside, of a horizontally positioned substrate. Neither does US 5,660,642 disclose how to remove efficiently a liquid from the topside of a horizontally positioned substrate.

Document U.S.-A-5,271,774 of Leenaars describes a process for removing a liquid from a surface of a substrate, which is subjected to a rotary movement. The substrate is rotated at a speed such that the liquid is centrifuged from the surface. Leenaars states that the liquid is initially present as a liquid film. During the treatment, a vapour is supplied to the substrate. Leenaars uses the combination of a vapour and a centrifugal force to remove the liquid from the substrate.

Leenaars does not disclose, or even suggest, that during the time in which the vapour is supplied, a further or extra liquid is also supplied. In fact, Leenaars only supplies a vapour to a substrate that can be covered with a liquid film.

The Japanese patent abstract JP-07 211686 of Tajima disclose a process to dry a substrate such as a wafer on the two opposite sides. First, a wafer is cleaned in a cleaning tank and further rinsed in a rinsing/ drying tank. In said rinsing/ drying tank, pure water is sprayed on the upper surface of the substrate such that the final rinse is performed.

Instead, the wafer is rotated and subsequently high temperature IPA vapour is delivered in the tank (on the opposite side of the substrate) while spin drying is sustained.

During this stage, no extra liquid is supplied on any other side of the wafer.

Both last states of the art are described as being subsequent treatments wherein first a liquid is applied on the surface of the substrate, followed by a vapour treatment.

SUMMARY OF THE INVENTION

In an aspect of the invention a method is disclosed, for removing a liquid from at least one surface of a substrate comprising the steps of:

- providing at least one substrate having at least one surface to be treated,
- subjecting said substrate to a rotary movement,
- supplying, from a liquid supply system, a liquid on at least a part of said surface of said substrate;
- and supplying, from a gaseous substance supply system, a gaseous substance to said surface of said substrate, said gaseous substance being supplied closer to the centre of rotation of said rotary movement, than said liquid, said gaseous substance being at least partially miscible with said liquid and when mixed with said liquid yielding a mixture having a surface tension being lower than that of said liquid

characterized in that said method comprises the steps of :

- supplying the gaseous substance initially at or very close to the centre of rotation of said rotary movement, while supplying the liquid out of centre but adjacent to the gaseous substance supply,
- by doing so, forming a liquid-vapour boundary on said surface of said substrate, which is initially located at said centre,
- moving both the liquid supply and the gaseous substance supply, such that the liquid-vapour boundary is guided outwards from the centre to the edge to thereby remove the liquid from said surface of said substrate.

Said rotary movement can be performed at a speed to guide said liquid-vapour boundary over said surface of said substrate.

According to a preferred embodiment, said rotary movement i.s applied on a single substrate such that said substrate rotates around its own centre. The rotation speed can be in the range from 2 to 40 revolutions per second.

According to another preferred embodiment, said gaseous substance comprises a vaporised substance which is miscible with said liquid and when mixed with said liquid yields a mixture having a surface tension being lower than that of said liquid. Preferably, said vaporised substance is selected from a group comprising isopropyl alcohol (IPA), diacetone, ethylglycol, ethyllactate and methylpyrrolidon or a mixture thereof.

According to a further preferred embodiment, said gaseous substance comprises a mixture of a vaporised substance and a gas, said mixture being at least partially miscible with said liquid and when mixed with said liquid yielding a mixture having a surface tension being lower than that of said liquid. Preferably, said vaporised substance is selected from a group comprising isopropyl alcohol (IPA), diacetone, ethylglycol and methylpyrrolidon or a mixture thereof and said gas is an inert gas.

According to another preferred embodiment, said gaseous substance comprises a gas which is miscible with said liquid and when mixed with said liquid yields a mixture having a surface tension being lower than that of said liquid. Said liquid can be one group of an etching liquid, a cleaning liquid or a rinsing liquid. Preferably, said liquid is a dilute aqueous solution. In particular, said liquid comprises a mixture of $NH_4OH$ and $H_2O$; or comprises a mixture of HCl, $H_2O_2$ and $H_2O$; or comprises diluted HCl; or comprises a mixture comprising $O_3$.

In particular, said liquid comprises $H_2O$; or a mixture of $H_2O$ and an acid, said mixture having a pH value between 2 and 6.

In another aspect of the present invention, an apparatus is disclosed for removing a liquid from at least one surface of a substrate according to claim 14.

According to a preferred embodiment, said apparatus further comprises a chamber wherein said substrate holder is positioned, said chamber being designed in a manner to avoid back splashing of said liquid on said surface of said substrate.

According to another preferred embodiment, said gaseous substance supply system comprises at least one nozzle for applying said gaseous substance on said surface of said substrate and said liquid supply system comprises at least one nozzle for applying said liquid on said part of said surface of said substrate, said nozzles are positioned such that said gaseous substance is applied closer to the centre of the rotary movement of the substrate holder than said liquid. Said nozzles can be mounted on an arm, said arm being movable relative to said substrate holder.

In particular, in an apparatus according to the invention, said nozzles are mounted on and fixed to an arm, said arm being movable relative to said substrate holder. Alternatively, said nozzles are mounted on a fixed arm, said nozzles being movable.

In an apparatus according the invention, said nozzles may be movable over a radial distance with respect to the centre of rotation of said rotary movement.

BRIEF DESCRIPTION OF THE DRAWINGS

Figure 1 depicts a schematic representation (vertical cross-section) of a tool used for removing a liquid from the topside of a surface of a rotating substrate according to an embodiment of the invention.

Figure 2 a) depicts a schematic representation, i.e. a top view, while fig. 2 b) depicts a cross-section (2b-2b) of a tool used for removing a liquid from a rotating substrate according to an embodiment of the invention.

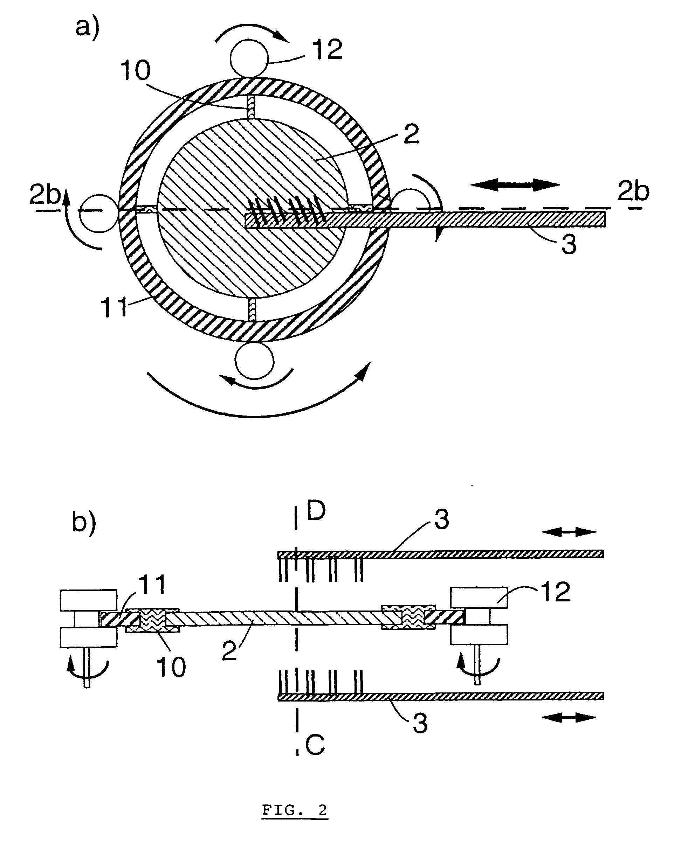

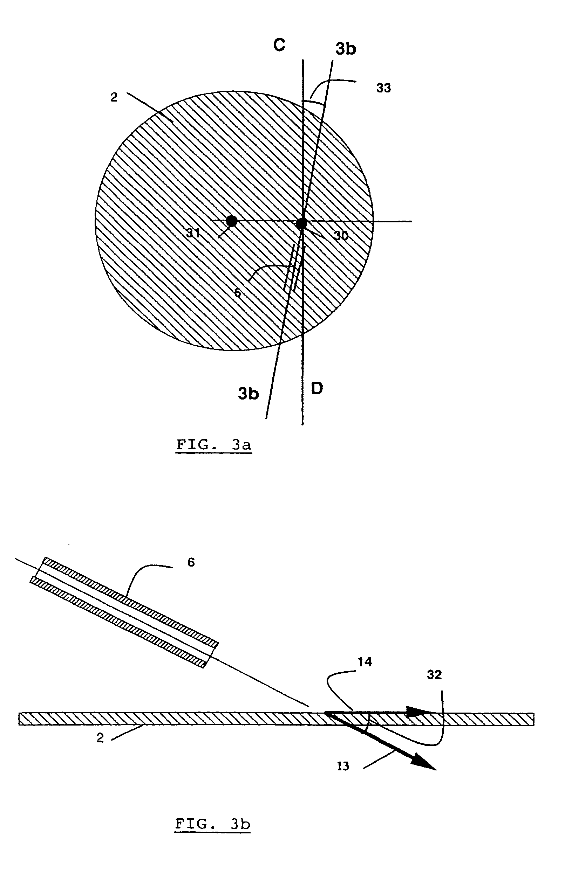

Figure 3 a) depicts a top view of the cross-sectional plane (C-D of fig 2 b)) perpendicular to the surface of the substrate through the point of liquid impingement (30) and perpendicular to the imaginary line connecting the point of liquid impingement and the rotation centre (31) of a tool used for removing a liquid from a rotating substrate. The vector representing the velocity of the liquid leaving the nozzle is in this cross-sectional plane (C-D) or in a plane (3b-3b) perpendicular to the surface of the substrate making a small angle (33) with (C-D), i.e. the liquid velocity vector can be slightly oriented outwards. Figure 3 b) depicts the 3b-3b plane.

Figure 4 a) depicts a schematic representation, i.e. a top view, while fig. 4 b) depicts a cross-section (4b-4b) of a tool used for removing a liquid from a rotating substrate.

DETAILED DESCRIPTION OF THE INVENTION

In relation to the appended drawings the present invention is described in detail in the sequel. Several embodiments are disclosed.

In an aspect of the invention a method of removing a liquid from at least one surface of at least one substrate is disclosed, said method comprising the steps of:

supplying a liquid on at least a part of said surface of said substrate;
supplying a gaseous substance to said surface of said substrate, said gaseous substance being at least partially miscible with said liquid and when mixed with said liquid yielding a mixture having a surface tension being lower than that of said liquid; and
subjecting said substrate to a rotary movement. Said gaseous substance can comprise a vaporised substance which is miscible with said liquid and when mixed with said liquid yields a mixture having a surface tension being lower than that of said liquid. A vaporised substance is defined as a mist of finely dispersed liquid droplets of an element or a compound or a mixture of elements or as a vapor. A vapor is defined as the gas phase occurrence of an element or of a compound or of a mixture of elements if the element or compound or mixture should be in the liquid or solid phase at the given temperature and pressure conditions. Thus a vapour can co-exist in one environment with the solid or liquid phase of the element. A vapour is a specific gas phase occurrence of an element or a compound or a mixture of elements. Said gaseous substance can comprise a gas which is miscible with said liquid and when mixed with said liquid yields a mixture having a surface tension being lower than that of said liquid. Said gaseous substance can comprise a mixture of a vaporised substance and a gas, particularly an inert gas like e.g. helium, argon or nitrogen, said mixture being at least partially miscible with said liquid and when mixed with said liquid yielding a mixture having a surface tension being lower than that of said liquid. Particularly, by supplying said liquid and said gaseous substance on said surface of said substrate, at least locally a sharply defined liquid-vapor boundary is created. Said boundary has to be such that, at least within the part of the surface which is not rewetted during a subsequent revolution, said boundary is a continuous one, i.e. said part is determined by the lateral movement of said boundary during a revolution. According to the method of the present invention, said rotary movement is performed at a speed to guide said liquid-vapor boundary over said substrate. The configuration is such that the liquid is kept at the liquid side of the liquid-vapor boundary.

According to an aspect of the invention, on at least one surface, preferably on both opposite surfaces simultaneously i.e. the top and bottomside, of at least one substrate fresh liquid is sprayed continuously. The entire surface at the liquid side of the liquid-vapor boundary can be covered with a film of the liquid. The speed of the rotary movement is chosen such that the flow of said sprayed liquid on said surface of the wafer is transported outwards due to the centrifugal forces. The rotational speed, the flow of the liquid supply, and the orientation and the velocity at which the liquid arrives on the surface can be optimized in order to result in a liquid film with a sharp and stable liquid-vapor boundary and to keep the thickness of the liquid film small enough to avoid excessive losses of liquid on the bottomside by gravitational forces. Moreover, said gaseous substance when mixed with the liquid, results in a surface tension reduction of said liquid thereby facilitating the movement of said liquid towards an edge of the substrate. The surface left behind is cleaned and dried. It is presumed that this drying action is obtained according to at least the combination of the Marangoni effect and a second force. Preferably this second force is the force introduced by a rotary movement or e.g. an oscillating movement. According to the Marangoni effect said substances will be mixed with the liquid such that in the liquid meniscus, its concentration decreases in the direction of the liquid. This gradient in concentration creates an additional force exerted on the liquid film in the direction of the liquid film resulting in a good drying performance. Particularly, the centre of the rotary movement can coincide with the centre of the substrate, i.e. the substrate spins around its own centre. In this case, if a liquid is sprayed on a surface of a substrate rotating typically with a speed between 2 and 20 revolutions per second, but the invention is not limited thereto, a curved shaped liquid-vapor boundary is created. The entire surface area outside of this curved boundary, can be covered with a film of the liquid. Particularly when using hydrophilic substrates, the entire surface area outside of this curved boundary is covered with a continuous film of the liquid However also other more complex shaped boundaries can be created, particularly on substrates with a high contact angle for the liquid and if a low flow of liquid is applied. Such complex shaped boundaries will also assist in removing a liquid.

The liquid is selected dependent on the applied wet processing step: for etching steps, e.g. dilute aqueous solutions comprising e.g. HF can be used; for cleaning steps, e.g. a mixture of $NH_4OH$, $H_2O_2$ and $H_2O$ or a mixture of HCl, $H_2O_2$ and $H_2O$ or dilute HCl or a mixture comprising $O_3$ can be used; for rinsing steps, the rinsing liquid can comprise $H_2O$, or a mixture of $H_2O$ and an acid, said mixture preferably having a pH between 2 and 6. Preferably said acid is one of the group of $HNO_3$, $H_2CO_3$, $HCO_3$, HCl, HBr, $H_3PO_4$, $H_2SO_4$. To initiate the removal process, besides said liquid also a gaseous substance is sprayed on at least one surface of said substrate. Said gaseous substance can comprise a substance, like e.g. isopropyl alcohol (IPA), diacetone, ethyllactate, ethylglycol, methylpyrrolidon or a mixture of one of the aforementioned substance, which when vaporised is miscible with said liquid and when mixed with said liquid yields a mixture having a surface tension being lower than that of said liquid

There are several implementations possible to apply both the liquid and the vapor of the surface tension reducing substance on at least one surface of at least one substrate. Preferably the implementation has to be such that the gaseous substance is supplied initially at or very close to the centre of the rotary movement, while the liquid is supplied out of centre but adjacent to the gaseous substance supply. The liquid can also be additionally supplied further away from said centre. By doing so on said surface of said substrate a liquid-vapor boundary can be formed which is initially located at said centre. Then, due to the rotary movement and the movement of the gaseous substance and liquid supply system, this boundary is slowly guided outwards from the centre to the edge to thereby remove the liquid or the solution of said liquid from said surface of said substrate. A sharply defined liquid-vapor boundary, at least locally, is helpful in order to obtain an optimal performance. The method of the present invention is perfectly suited to handle a horizontal positioned substrate resulting in a secure and reliable approach which is compatible with substrate handling in most of the other process steps in the manufacturing of integrated circuits. Moreover because, according to the present invention, the liquid of the liquid-vapor boundary is continuously refreshed, besides a good drying performance also a better cleaning performance is obtained simultaneously. A better cleaning performance can be obtained regardless of the precise nature of the liquid, i.e. a wet processing liquid like e.g. a cleaning liquid or a rinsing liquid or a wet etching liquid, as long as the liquid is miscible with the surface tension reducing gaseous substance. Particularly said liquid can be a dilute aqueous solution. Furthermore the required amounts of liquid are substantially lower compared with conventional wet processing baths or tanks.

According to an aspect of the present invention first the liquid can be supplied on a surface of a substrate at or very close to the centre of the rotary movement, while there is no gaseous substance supply. Then, the liquid supply is moved slightly out of said centre and the gaseous substance is supplied at said centre.

Further according to an aspect of the present invention first the liquid can be supplied on a surface of a substrate at or very close to the centre of the rotary movement, while substantially simultaneously the gaseous substance is supplied adjacent to said liquid supply. Then, the liquid supply is moved slightly out of said centre, while the gaseous substance supply is moved to said centre. Once a liquid-vapor boundary is established, at least locally, both the liquid supply and the gaseous substance supply are moved such that the liquid-vapor boundary is guided outwards.

In another aspect of the invention the centre of the rotary movement coincides with the centre of the substrate, i.e. the substrate rotates around its own centre. Then the gaseous substance supply system, e.g. a nozzle is moved to the centre of the rotary movement, i.e. the centre of the substrate, and the pressurised gaseous substance is supplied actively at said centre while the liquid is supplied slightly out of centre. The liquid can also be supplied further away from said centre. By doing so on said surface of said substrate a liquid-vapor boundary is formed which is initially located at said centre. Then, due to the rotary movement and the movement of the gaseous substance and liquid supply system, this boundary is slowly guided outwards from the centre to the edge of said surface of said substrate to thereby remove the liquid or the solution of said liquid from said surface of said substrate.

In another aspect of the invention, in order to enhance the cleaning performance of the liquid removal process of the present invention, an additional force can be exerted on the liquid, particularly on the liquid near the liquid-vapor boundary. Particularly, said liquid can be agitated by using megasonic energy. This megasonic energy can be generated locally by a generator and transmitted to the liquid. Particularly, said generator can be integrated in the liquid supply system and directly transmitting the megasonic energy to the liquid. Then, this megasonic energy is transferred to the surface of the substrate via the liquid. In an implementation a megasonic liquid nozzle or jet is used. This megasonic liquid nozzle consist of a liquid nozzle and a generator. The liquid which is dispensed on the surface by this megasonic liquid nozzle is agitated by means of said generator. Because there is a continuous flow between the megasonic liquid nozzle and the surface, the megasonic energy is transferred to the surface via the liquid to thereby enhance the cleaning performance of the liquid. This megasonic liquid nozzle can be mounted on an arm together with a gaseous substance supply nozzle. In another implementation, a megasonic arm can be used. This megasonic arm consists of a megasonic generator and a liquid supply system. Particularly said megasonic generator comprises a transducer and a transmitter. Preferably this transmitter has a cylindrical shape and extends along said arm. Said megasonic arm extends over a surface of a substrate, preferably close to said surface. Liquid can be supplied to said surface of the substrate. This liquid is confined between said surface and said arm. So again the megasonic energy can be transmitted to the liquid by means of the transmitter and subsequently via said liquid to the surface of the substrate. Preferably, to maximize the capillary effect during the liquid removal process of the present invention, the distance between the arm and the surface of the substrate is about 0.5 mm or less, but the invention is not limited thereto.

In an aspect of the invention an apparatus for removing a liquid from at least one surface of at least one substrate is disclosed, said apparatus comprising:

a substrate holder (1) (11) which is subjectable to a rotary movement, said substrate (2) being releasably held said substrate holder;
a liquid supply system (5) for applying a liquid on at least a part of said surface of said substrate;
a gaseous substance supply system (4) for applying a gaseous substance on said surface of said substrate, and where said gaseous substance supply system and said liquid supply system are positioned such that said gaseous substance is applied closer to the centre of said rotary movement of said substrate holder than said liquid.

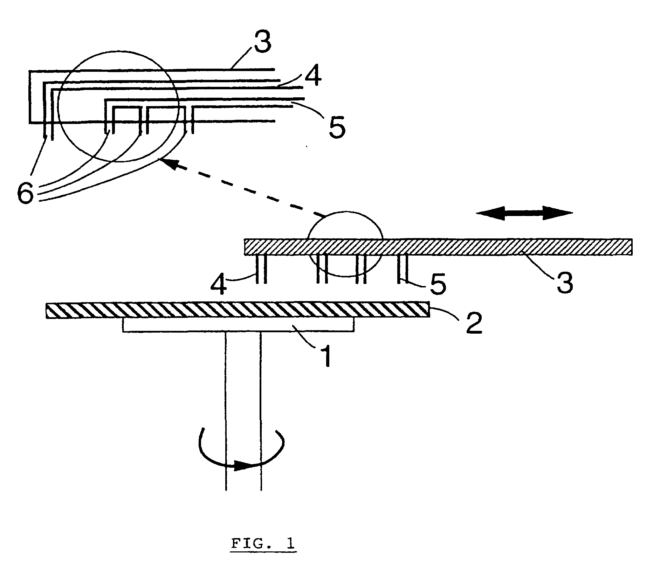

In an aspect of the invention, as illustrated in figure 1, a substrate (2) is placed on a revolving substrate holder (1). Said substrate can be placed in a chamber of a tool comprising at least one chamber. Said substrate holder and the substrate thereon are rotating with a speed which is typically between 2 and 20 or more revolutions per second. A movable arm (3), which can be guided between the centre and the edge of the substrate extends above the topside of the substrate. Initially one end of this arm is located near the centre of the rotary movement, i.e. the centre of the substrate. Said arm comprises at least two supply systems, a first supply system comprising means (4) for supplying a surface tension reducing gaseous substance to the substrate, a second supply system comprising means (5) for supplying a liquid to the substrate. Said first supply system further comprises at least one nozzle, initially being placed at or near the centre of the substrate, for spraying said gaseous substance on said substrate. Said second supply system further comprises at least one nozzle, being placed more outwards than said nozzle for spraying gaseous substance, for spraying said liquid on said substrate. Alternatively, instead of a movable arm comprising fixed nozzles also movable nozzles on a fixed arm can be used. To ensure that each part of the substrate is effectively dried, the translation speed, v, at which the arm, i.e. the nozzles, moves can be adapted to the rotational (angular) speed, $\omega$, of the substrate. Suppose that $\Delta r$ is the translation distance, being the radial distance over which the liquid-vapor boundary extends radialy during one revolution, then the rotational speed can be chosen such that:

$$\Delta r = \frac{2\pi\ v}{\omega}$$

For example, suppose that the translation distance per revolution, $\Delta r$, equals 1 mm and that the translation speed, v, equals 1 mm per second, then the rotational speed is 1 revolution per second.

In tests, the nozzles are located such that their centre lines will draw concentric circles on the surface with a difference in radius on the order of 5 mm. By doing so, at the topside of the substrate a curved liquid-vapor boundary is formed which is initially located at said centre of the substrate. Then this boundary is slowly guided outwards by moving said arm (3) from the centre to the edge of the substrate to thereby remove the liquid or the solution of said liquid from the topside of said substrate. The liquid-vapor boundary is located in between the nozzle providing the surface tension reducing gaseous substance and the nearest nozzle spraying the liquid. Using this method fresh liquid with very low concentration of the surface tension reducing gaseous substance is supplied at the liquid-vapor boundary thus maximizing the removal of the liquid (maximizing Marangoni force). In figure 1 the nozzles (6) are placed such that the gaseous substance is sprayed perpendicular, i.e. at an angle of 90°, on the substrate and also the liquid is sprayed on the substrate. Spraying the liquid can be done such that at least locally a sharp and stable curved boundary is obtained, and particularly in case hydrophilic substrates are used the entire surface of the substrate at the outside of the boundary is kept wet. This will involve optimization of the orientation of the liquid nozzle (s) and of the velocity of the liquid leaving the nozzle. In order to limit splashing of the liquid the angle (32) between the velocity vector of the liquid (figure 3 (13)) when leaving the nozzle and the velocity vector of the rotating surface (figure 3 (14)) at the point (30) where the liquid flow impinges can be kept small. Eventually, the liquid nozzles can also be slightly oriented outwards, i.e. typically at an angle (33) between 0 degrees and 5 degrees. For removing a liquid having a low contact angle in contact with the surface, it is found sufficient to have only one nozzle for supplying the liquid. In case of higher contact angles, in order to maintain a wet substrate surface outside the drying boundary, additional nozzles for spraying liquid can be installed at equal or greater distance from the rotation centre (31). In order to further limit the consumption of the liquid the additional nozzles can be turned off as they move over the substrate edge. It may be useful to progressively modulate the flow and the rotation speed as the drying proceeds from the centre towards the edge of the substrate.

According to this aspect of the invention, as an example, experiments are performed using such an apparatus for removing a liquid from the topside of a substrate. Particularly, the gaseous substance supply system of said apparatus comprises one nozzle and the liquid supply system of said apparatus also comprises one nozzle. Said nozzles are mounted on an arm, said arm being movable relative to said substrate. The substrates used in the experiments are silicon wafers with a diameter of 150 mm with a deposited oxide layer on top. The thickness of the oxide layer is 1.1 $\mu$m. The wafers are polished by means of chemical mechanical polishing. After this treatment, the thickness of the remaining oxide layer is 700 nm. Immediately thereafter the wafers are put in a water container.

In a first test a state of the art method is used to remove the water from the topside of a wafer. The wafer is placed on a substrate holder and subjected to a rotary movement at a speed of 600 revolutions per minute during 40 seconds while only a surface tension reducing gaseous substance, i.e. a mixture of vaporised isopropyl alcohol (IPA) and nitrogen, is supplied. The experiment is performed in a class 10000 cleanroom area. After this removal treatment light point-defects (LPD's), being a measure for the number of contamination particles, are measured using a Tencor Surfscan 6400. The number of LPD's per wafer measured with a polystyrene latex sphere equivalent (PSLSE) diameter between 0.2 and 0.3 $\mu$m is 309 with a standard deviation of 113. These numbers are an average of LPD measurements on two different wafers which were subjected to the same treatment according to this first experiment.

In a second test, according to this aspect of the present invention a method is used to remove the water from the topside of a wafer. The wafer is placed on a substrate holder and subjected to a rotary movement at a speed of 600 revolutions per minute during 15 seconds or 25 seconds. A pressurized surface tension reducing gaseous substance, i.e. a mixture of vaporised isopropyl alcohol (IPA) and nitrogen, is actively supplied by the first nozzle, while a liquid, i.e. fresh water, is actively supplied by the second nozzle. The arm comprising the nozzles is moved from the centre to the edge with a radial velocity of 5 mm per second or 3 mm per second. The experiment is performed outside a cleanroom area. After this removal treatment light point-defects (LPD's), being a measure for the number of contamination particles, are measured using a Surfscan 6400. The number of LPD's per wafer measured with a PSLSE diameter between 0.2 and 0.3 $\mu$m is 14 with a standard deviation of 5. These numbers are an average of LPD measurements on six different wafers, 3 which are subjected to the same treatment, i.e. with a radial velocity of 5 mm per second, and the other three wafers which are also subjected to the same treatment, i.e. with a radial velocity of 3 mm per second according to this second experiment. From the LPD measurements it is clear that the method of the present invention has a better cleaning and drying performance, particularly with regard to particles.

In an aspect of the invention, as illustrated in figure 2, a substrate (2) can be clamped into a ring-shaped substrate holder (11) having an inner diameter larger than the diameter of the substrate. The clamping is done using minimal contact surface. The substrate holder or alternatively the substrate itself is placed between at least two revolving means (12) which transmit the rotational force to said substrate holder comprising the substrate or alternatively to said substrate alone. Said substrate holder comprising said substrate or said substrate alone can be placed in a chamber of a tool comprising at least one chamber. Said substrate is rotating with a speed which is typically between 2 and 40 revolutions per second, or between 1 and 100 revolutions per second, or between 10 and 60 revolutions per second. Two movable arms (3), which can be guided separately or simultaneously between the centre and the edge of the substrate extend above the topside and below the bottomside of the substrate. Initially one end of each of these arms is located near the centre of the substrate. Each of these arms comprises at least two supply systems, a first supply system comprising means (4) for supplying a surface tension reducing gaseous substance to the substrate, a second supply system comprising means (5) for supplying a liquid to the substrate. Said first supply system further comprises at least one nozzle, being placed near the centre of the substrate, for spraying said gaseous substance on said substrate. Said second supply system further comprises at least one nozzle, being placed more outwards than said nozzle for spraying gaseous substance, for spraying said liquid on said substrate. By doing so both at the topside and on the bottomside of the substrate a liquid-vapor boundary can be formed which is located at said centre of the substrate. Then this boundary is slowly guided outwards by moving said arms (3) from the centre to the edge of the substrate to thereby remove the liquid or the solution of said liquid from the surfaces of said substrate. In order to limit splashing of the liquid the angle between the velocity of the liquid (figure 3 (13)) when leaving the nozzle and the velocity of the rotating surface (figure 3 (14)) at the point where the liquid flow impinges can be kept small.

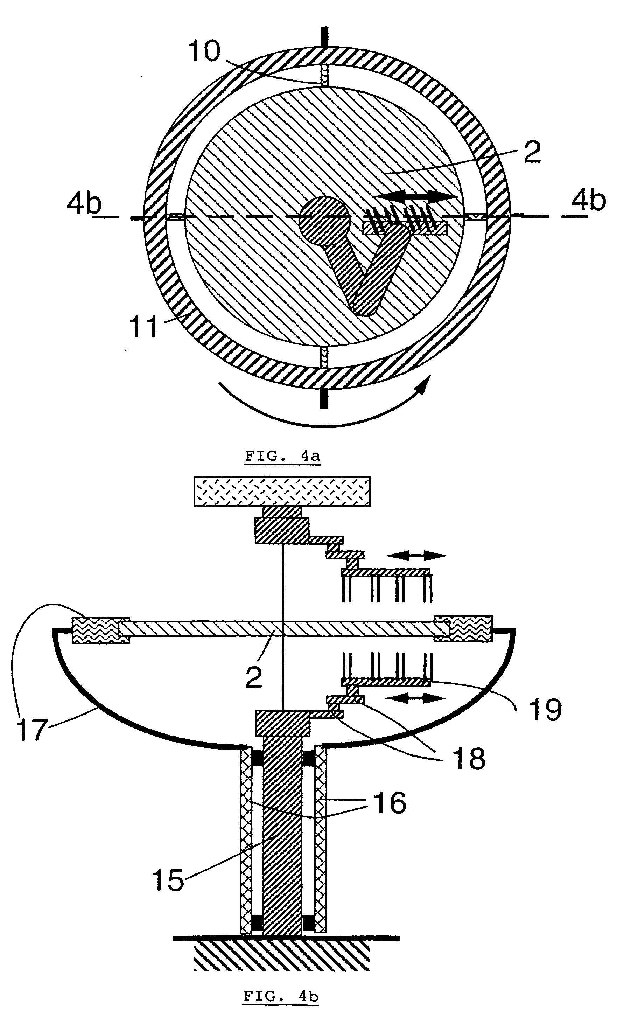

Another approach for building this rotation system is shown in figure 4. In this case, at the bottomside is, a set of arms (18) with a bar of nozzles (19) attached thereon at the bottomside is mounted on a central shaft (15). Around this shaft a hollow shaft (16) is rotating. On this hollow shaft the clamping means (17) of the substrate are fixed. The set of arms moving over a radius of the substrate comprises at least a first arm and a second arm and can be made compact, i.e. like a man's arm. Said first arm is connected to said shaft to rotate about a first axis orthogonal to and through the rotation centre of the substrate holder. Said second arm is parallel to but offset from the first arm with the first arm and the second arm being rotatably connected at a joint to rotate about an axis parallel to the first axis. The set of arms on the topside can be similar, but no rotation gear is required at the topside.

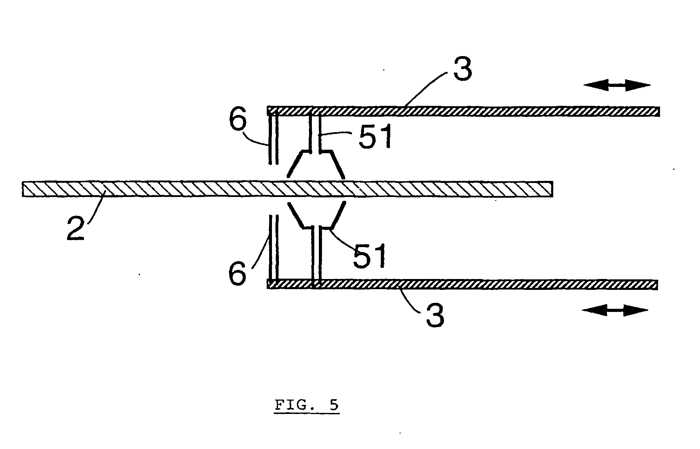

In an aspect of the invention (fig. 5), the liquid supply system (3) comprises a cup-shaped nozzle (51) which can be guided over the rotating substrate(2) and which is positioned very close to a surface of a substrate. Particularly, the distance between this cup-shaped nozzle and a surface of the substrate is typically about 0.5 mm. The liquid, e.g. water, can be supplied through the cup.

In another aspect of the invention, said apparatus further comprises a generator of megasonic energy and a transmitter for transmitting said megasonic energy to a surface of the substrate via the liquid being supplied at said surface. In particular a megasonic liquid jet or a megasonic arm can be used

In another aspect of the invention, the gaseous substance supply system comprises at least one static inlet for applying said gaseous substance on said surface of said substrate and the liquid supply system comprises at least one nozzle for applying said liquid on said surface of said substrate. Particularly, at least locally, a sharply defined liquid-vapor boundary can be created being located between the rotation centre and the liquid supply nozzle being located at the shortest radial distance from the rotation centre. Further according to the apparatus of the invention, said liquid nozzles can be mounted on an arm, said nozzles being movable on said arm and/or said arm being movable relative to said substrate.

In further tests, the nozzles are positioned in order to draw concentric circles on the surface with a difference in radius in the order of 6 mm. One nozzle is provided to spray the liquid, i.e. $H_2O$ on a surface of a 150 mm silicon wafer. The rate of the liquid flow is about 60 ml per minute. The surface tension reducing gaseous substance used is a mixture of vaporised IPA and a nitrogen gas. The rotation speed is about 300 revolutions per minute. These conditions are suited to remove the liquid very efficiently for hydrophilic wafers. It is found that particularly for hydrophobic silicon wafers, it is important to have a sufficiently high liquid supply to keep the outer parts of the wafer wet. Preferably additional nozzles can be provided to ensure this.

According to an aspect of the present invention, the same rotation station can be used to perform a wet chemical processing step like e.g. a wet etching step, wet cleaning and rinsing a substrate, or to perform an arbitrary sequence of such wet processing steps. In an embodiment of the invention, prior to the initiation of the liquid removal process, i.e. prior to supplying a surface tension reducing gaseous substance, an etching, cleaning or rinsing liquid or a continuous sequence of such liquids can be supplied to at least one surface of the substrate. For example, this can be done by using at least one of the liquid nozzles (and eventually additional nozzles further away from the centre). The parameters can be optimized such that a continuous liquid film is present on the surface. The spinning motion will quickly transport the liquid over the surface towards the edge, thus allowing relatively short carry-over transients and thus also allowing for relatively short rinsing times. Using such a continuously switched flow of liquids eliminates the passage of liquid-gas interfaces over the surface. The liquid removal method of the present invention is applicable for each sequence of at least one wet processing step by supplying a surface tension reducing gaseous substance together with the liquid. The removal method can thus be applied directly on the processing liquid if beneficial for the application. Since the proposed removal method is found to be very fast, process non-uniformity over the surface, i.e. centre to edge or edge to edge, can be kept very low.

**Claims**

1. A method for removing a liquid from at least one surface of a substrate comprising the steps of:

   - providing at least one substrate (2) having at least one surface to be treated,
   - subjecting said substrate to a rotary movement,
   - supplying, from a liquid supply system (5), a liquid on at least a part of said surface of said substrate;
   - and supplying, from a gaseous substance supply system (4), a gaseous substance to said surface of said substrate, said gaseous substance being supplied closer to the centre of rotation of said rotary movement, than said liquid, said gaseous substance being at least partially miscible with said liquid and when mixed with said liquid yielding a mixture having a surface tension being lower than that of said liquid,

   **characterized in that** said method comprises the steps of :

   - supplying the gaseous substance initially at or very close to the centre of rotation of said rotary movement, while supplying the liquid out of centre but adjacent to the gaseous substance supply,

- by doing so, forming a liquid-vapour boundary on said surface of said substrate, which is initially located at said centre,

moving both the liquid supply and the gaseous substance supply, such that the liquid-vapour boundary is guided outwards from the centre to the edge to thereby remove the liquid from said surface of said substrate.

2. A method according claim 1, wherein said rotary movement is performed at a certain speed to guide said liquid-vapor boundary over said surface of said substrate.

3. A method according to claim 2, wherein said rotary movement is on a single substrate (2) applied such that said substrate rotates around its own centre.

4. A method according to claim 3, wherein the rotation speed is in the range from 2 to 40 revolutions per second.

5. A method according to claim 1, wherein said gaseous substance comprises a vaporised substance which is miscible with said liquid and when mixed with said liquid yields a mixture having a surface tension being lower than that of said liquid.

6. A method according to claim 5, wherein said vaporised substance is selected from a group comprising isopropyl alcohol (IPA), diacetone, ethylglycol, ethyllactate and methylpyrrolidon or a mixture thereof.

7. A method according to claim 1, wherein said gaseous substance comprises a mixture of a vaporised substance and a gas, said mixture being at least partially miscible with said liquid and when mixed with said liquid yielding a mixture having a surface tension being lower than that of said liquid.

8. A method according to claim 7, wherein said vaporised substance is selected from a group comprising isopropyl alcohol (IPA), diacetone, ethylglycol and methylpyrrolidon or a mixture thereof and said gas is an inert gas.

9. A method according to claim 1, wherein said gaseous substance comprises a gas which is miscible with said liquid and when mixed with said liquid yields a mixture having a surface tension being lower than that of said liquid.

10. A method according to claim 1, wherein said liquid is one of a group of an etching liquid, a cleaning liquid or a rinsing liquid.

11. A method according to claim 1, wherein said liquid is a dilute aqueous solution.

12. A method according to claim 10, wherein said liquid comprises a mixture of $NH_4OH$, $H_2O_2$ and $H_2O$; or comprises a mixture of $HCl$, $H_2O_2$ and $H_2O$; or comprises diluted $HCl$; or comprises a mixture comprising $O_3$.

13. A method according to claim 10, wherein said liquid comprises $H_2O$; or a mixture of $H_2O$ and an acid, said mixture having a pH value between 2 and 6.

14. An apparatus for removing a liquid from at least one surface of a substrate (2) according to the method of anyone of the preceding claims, said apparatus comprising:

a substrate holder (1) which is subjectable to a rotary movement, said substrate holder (1) being designed to releasably held said substrate (2);
at least one liquid supply system (5) for applying a liquid on at least a part of said surface of said substrate (2);
at least one gaseous substance supply system (4) for applying a gaseous substance on said surface of said substrate (2)

wherein said gaseous substance supply system (4) and said liquid supply system (5) are positioned such that said gaseous substance is applied closer to the centre of said rotary movement of said substrate holder (1) than said liquid, **characterised in that** both said liquid supply system (5) and said gaseous substance supply system are designed to move with respect to said substrate holder (1), and said systems are designed to guide a liquid-vapor boundary formed on the surface and initially located at the centre of rotation of said substrate, outwards from said centre to the edge of the substrate to thereby remove the liquid from said surface of said substrate.

15. An apparatus according to claim 14, further comprising a chamber wherein said substrate holder is positioned, said chamber being designed to avoid back splashing of said liquid on said surface of said substrate.

16. An apparatus according to claim 14, wherein said gaseous substance supply system (4) comprises at least one nozzle (6) for applying said gaseous substance on said surface of said substrate and said liquid supply system (5) comprises at least one nozzle (6) for applying said liquid on said part of said surface of said substrate, said nozzles (6) being positioned such that said gaseous substance is applied closer to the centre of the rotary movement of the substrate holder than said liquid.

17. An apparatus according to claim 16, wherein said nozzles (6) are mounted on and fixed to an arm (3), said arm being movable relative to said substrate holder (1).

18. An apparatus according to claim 16, wherein said nozzles (6) are mounted on a fixed arm, said nozzles being movable.

**Patentansprüche**

1. Verfahren zum Entfernen einer Flüssigkeit von mindestens einer Oberfläche eines Substrats, welches die nachfolgenden Verfahrensschritte umfasst:

   - ein Bereitstellen von mindestens einem Substrat (2) mit mindestens einer zu behandelnden Oberfläche,

   - eine Vornahme einer Drehbewegung an dem besagten Substrat,

   - ein Zuführen einer Flüssigkeit ausgehend von einem Flüssigkeitszufuhrsystem (5) hin auf mindestens einen Teil der besagten Oberfläche des besagten Substrats, und

   - ein Zuführen einer gasförmigen Substanz ausgehend von einem Zufuhrsystem für eine gasförmige Substanz (4) hin auf die besagte Oberfläche des besagten Substrats, wobei die besagte gasförmige Substanz näher an den Drehungsmittelpunkt der besagten Drehbewegung heran gebracht wird als die besagte Flüssigkeit, wobei die besagte gasförmige Substanz mindestens teilweise mit der besagten Flüssigkeit mischbar ist und wobei dieselbe nach dem Vermischen mit der besagten Flüssigkeit eine Mischung mit einer Oberflächenspannung ergibt, welche kleiner ist als diejenige der besagten Flüssigkeit,

   **dadurch gekennzeichnet, dass** das besagte Verfahren die Schritte aufweist, welche bestehen aus:

   - einem Zuführen der gasförmigen Substanz anfänglich an den Drehungsmittelpunkt der besagten Drehbewegung oder sehr nahe an denselben heran, während die Flüssigkeit außerhalb des Mittelpunktes zugeführt wird, aber angrenzend an die Zufuhr für die gasförmige Substanz,

   - einem Bilden, infolge eines derartigen Vorgehens, einer Flüssigkeits-Dampf-Grenze auf der besagten Oberfläche des besagten Substrats, welche anfänglich an dem besagten Mittelpunkt gelegen ist,

   - einem Bewegen sowohl der Flüssigkeitszufuhr als auch der Zufuhr für die gasförmige Substanz, derart, dass die Flüssigkeits-Dampf-Grenze von dem Mittelpunkt ausgehend nach außen hin geleitet wird hin zu dem Rand, um auf diese Weise die Flüssigkeit von der besagten Oberfläche des besagten Substrats zu entfernen.

2. Verfahren gemäß Anspruch 1, bei welchem die besagte Drehbewegung mit einer bestimmten Geschwindigkeit durchgeführt wird, um jene Flüssigkeits-Dampf-Grenze über die besagte Oberfläche des besagten Substrats zu leiten.

3. Verfahren gemäß Anspruch 2, bei welchem die besagte Drehbewegung an einem einzelnen Substrat (2) ausgeübt wird, derart dass das besagte Substrat sich um seinen eigenen Mittelpunkt herumdreht.

4. Verfahren gemäß Anspruch 3, bei welchem die Drehgeschwindigkeit in dem Bereich von 2 bis 40 Umdrehungen pro Sekunde liegt.

5. Verfahren gemäß Anspruch 1, bei welchem die besagte gasförmige Substanz eine verdampfte Substanz enthält, welche mit der besagten Flüssigkeit mischbar ist und nach dem Vermischen mit der besagten Flüssigkeit eine Mischung ergibt mit einer Oberflächenspannung, welche kleiner ist als diejenige der besagten Flüssigkeit.

6. Verfahren gemäß Anspruch 5, bei welchem die besagte verdampfte Substanz ausgewählt wird aus einer Gruppe enthaltend Isopropylalkohol (IPA), Diaceton, Ethylglycol, Ethylacetat und Methylpyrrolidon oder eine Mischung derselben.

7. Verfahren gemäß Anspruch 1, bei welchem die besagte gasförmige Substanz eine Mischung aus einer verdampften Substanz und aus einem Gas enthält, wobei die besagte Mischung mindestens teilweise mit der besagten Flüssigkeit mischbar ist und nach dem Vermischen mit der besagten Flüssigkeit eine Mischung ergibt mit einer oberflächenspannung, welche kleiner ist als diejenige der besagten Flüssigkeit.

8. Verfahren gemäß Anspruch 7, bei welchem die besagte verdampfte Substanz ausgewählt wird aus einer Gruppe enthaltend Isopropylalkohol (IPA), Diaceton, Ethylglycol und Methylpyrrolidon oder eine Mischung derselben und bei dem das besagte Gas aus einem Inertgas besteht.

9. Verfahren gemäß Anspruch 1, bei welchem die besagte gasförmige Substanz ein Gas enthält, welches mit der besagten Flüssigkeit mischbar ist und nach dem Vermischen mit der besagten Flüssigkeit eine Mischung ergibt mit einer Oberflächenspannung, welche kleiner ist als diejenige der besagten Flüssigkeit.

10. Verfahren gemäß Anspruch 1, bei welchem die besagte Flüssigkeit eine solche aus einer Gruppe einer Ätzflüssigkeit, einer Reinigungsflüssigkeit oder einer Spülflüssigkeit ist.

11. Verfahren gemäß Anspruch 1, bei welchem die besagte Flüssigkeit eine verdünnte, wässrige Lösung ist.

12. Verfahren gemäß Anspruch 10, bei welchem die besagte Flüssigkeit eine Mischung enthält aus $NH_4OH$, $H_2O_2$ und $H_2O$; oder eine Mischung enthält aus HCL, $H_2O_2$ und $H_2O$; oder verdünntes HCL enthält; oder eine $O_3$ aufweisende Mischung enthält.

13. Verfahren gemäß Anspruch 10, bei welchem die besagte Flüssigkeit $H_2O$ enthält; oder eine Mischung aus $H_2O$ und einer Säure, wobei die besagte Mischung einen pH-Wert zwischen 2 und 6 aufweist.

14. Gerät zum Entfernen einer Flüssigkeit von mindestens einer Oberfläche eines Substrats (2) gemäß dem Verfahren nach irgendeinem der vorhergehenden Ansprüche, wobei das besagte Gerät umfasst:

einen Substrathalter (1), der einer Drehbewegung unterworfen werden kann, wobei der besagte Substrathalter so ausgelegt ist, dass er das besagte Substrat (2) auf eine loslösbare Art und Weise hält;

mindestens ein Flüssigkeitszufuhrsystem (5) zum Auftragen einer Flüssigkeit auf mindestens einen Teil der besagten Oberfläche des besagten Substrats (2);

mindestens ein Zufuhrsystem für eine gasförmige Substanz (4) zum Auftragen einer gasförmigen Substanz auf die besagte Oberfläche des besagten Substrats (2);

wobei das besagte Zufuhrsystem für eine gasförmige Substanz (4) und das besagte Flüssigkeitszufuhrsystem (5) derart angeordnet sind, dass die besagte gasförmige Substanz näher an dem Mittelpunkt der besagten Drehbewegung des besagten Substrathalters (1) aufgetragen wird als die besagte Flüssigkeit,

**dadurch gekennzeichnet, dass** sowohl das besagte Flüseigkeitszufuhrsystem (5) als auch das besagte Zufuhrsystem für eine gasförmige Substanz ausgelegt sind, um sich in Bezug auf den besagten Substrathalter (1) zu bewegen, und dass die besagten Systeme ausgelegt sind, um eine Flüssigkeits-Dampf-Grenze, die auf der Oberfläche gebildet wird und die sich anfänglich im Drehungsmittelpunkt des besagten Substrats befindet, von dem besagten Mittelpunkt ausgehend nach außen hin geleitet wird hin zu dem Rand des Substrats, um auf diese Weise die Flüssigkeit von der besagten Oberfläche des besagten Substrats zu entfernen.

15. Gerät gemäß Anspruch 14 welches weiterhin eine Kammer umfasst, in welcher der besagte Substrathalter angeordnet ist, wobei die besagte Kammer ausgelegt wird, um ein Zurückspritzen der besagten Flüssigkeit auf die besagte Oberfläche des besagten Substrats zu vermeiden.

16. Gerät gemäß Anspruch 14, bei welchem das Zufuhrsystem für eine gasförmige Substanz (4) mindestens eine Düse (6) zum Auftragen der besagten gasförmigen Substanz auf die besagte Oberfläche des besagten Substrats aufweist und bei welchem das besagte Flüssigkeitszufuhrsystem (5) mindestens eine Düse (6) zum Auftragen der besagten Flüssigkeit auf den besagten Teil der besagten Oberfläche des besagten Substrats aufweist, wobei die besagten Düsen (6) derart angeordnet sind, dass die besagte gasförmige Substanz näher an dem Mittelpunkt der Drehbewegung des Substrathalters aufgetragen wird als die besagte Flüssigkeit.

17. Gerät gemäß Anspruch 16, bei welchem die besagten Düsen (6) auf einem Arm (3) montiert und an demselben befestigt sind, wobei der besagte Arm beweglich ist in Bezug auf den besagten Substrathalter (1).

18. Gerät gemäß Anspruch 16, bei welchem die besagten Düsen (6) auf einem festen Arm montiert sind, wobei die besagten Düsen beweglich sind.

**Revendications**

1. Procédé pour retirer un liquide à partir d'au moins une surface d'un substrat comprenant les étapes consistant:

   - à fournir au moins un substrat (2) possédant au moins une surface à traiter,
   - à soumettre ledit substrat à un mouvement rotatif,

- à approvisionner, à partir d'un système d'approvisionnement de liquide (S), un liquide sur au moins une partie de ladite surface dudit substrat,
- et à approvisionner, à partir d'un système d'approvisionnement de substance gazeuse (4), une substance gazeuse vers ladite surface dudit substrat, ladite substance gazeuse étant approvisionnée plus près du centre de rotation dudit mouvement rotatif que ledit liquide, ladite substance gazeuse étant au moins partiellement miscible avec ledit liquide et lorsqu'elle est mélangée avec ledit liquide donne un mélange présentant une tension superficielle qui est inférieure à celle dudit liquide,

**caractérisé en ce que** ledit procédé comprend les étapes consistant:

- à approvisionner la substance gazeuse initialement au centre de rotation dudit mouvement rotatif ou très près de celui-ci, tout en approvisionnant le liquide hors du centre mais adjacent à l'approvisionnement de substance gazeuse,
- en faisant ceci, à former une frontière liquide-vapeur sur ladite surface dudit substrat, qui est initialement localisée audit centre,
- à déplacer à la fois l'approvisionnement de liquide et l'approvisionnement de substance gazeuse, de sorte que la frontière liquide-vapeur est guidée vers l'extérieur depuis le centre vers le bord pour retirer de cette manière le liquide à partir de ladite surface dudit substrat.

2. Procédé selon la revendication 1, dans lequel ledit mouvement rotatif est effectué à une certaine vitesse pour guider ladite frontière liquide-vapeur sur ladite surface dudit substrat.

3. Procédé selon la revendication 2, dans lequel ledit mouvement rotatif est appliqué sur un seul substrat (2) de sorte que ledit substrat tourne autour de son propre centre.

4. Procédé selon la revendication 3, dans lequel la vitesse de rotation varie entre 2 à 40 révolutions par seconde.

5. Procédé selon la revendication 1, dans lequel ladite substance gazeuse comprend une substance évaporée qui est miscible avec ledit liquide et lorsqu'elle est mélangée avec ledit liquide donne un mélange présentant une tension superficielle qui est inférieure à celle dudit liquide.

6. Procédé selon la revendication 5, dans lequel ladite substance évaporée est choisie dans un groupe comprenant de l'alcool d'isopropyle (IPA), du diacétone, du glycol éthylique, du lactate d'éthyle et du méthylpyrrolidone ou un mélange de ceux-ci.

7. Procédé selon la revendication 1, dans lequel ladite substance gazeuse comprend un mélange d'une substance évaporée et d'un gaz, ledit mélange étant au moins partiellement miscible avec ledit liquide et lorsqu'il est mélangé avec ledit liquide donne un mélange présentant une tension superficielle qui est inférieure à celle dudit liquide.

8. Procédé selon la revendication 7, dans lequel ladite substance évaporée est choisie dans un groupe comprenant de l'alcool d'isopropyle (IPA), du diacétone, du glycol éthylique et du méthylpyrrolidone ou un mélange de ceux-ci et ledit gaz est un gaz inerte.

9. Procédé selon la revendication 1, dans lequel ladite substance gazeuse comprend un gaz qui est miscible avec ledit liquide et lorsqu'il est mélangé avec ledit liquide donne un mélange présentant une tension superficielle qui est inférieure à celle dudit liquide.

10. procédé selon la revendication 1, dans lequel ledit liquide est un élément d'un groupe d'un liquide d'attaque, d'un liquide de nettoyage ou d'un liquide de rinçage.

11. Procédé selon la revendication 1, dans lequel ledit liquide est une solution aqueuse diluée.

12. Procédé selon la revendication 10, dans lequel ledit liquide comprend un mélange de $NH_4OH$, de $H_2O_2$ et de $H_2O$; ou comprend un mélange de HCl, de $H_2O_2$ et de $H_2O$; ou comprend HCl dilué; ou comprend un mélange comprenant $O_3$.

13. Procédé selon la revendication 10, dans lequel ledit liquide comprend $H_2O$; ou un mélange de $H_2O$ et d'un acide, ledit mélange présentant une valeur de pH comprise entre 2 et 6.

14. Appareil pour retirer un liquide à partir d'au moins une surface d'un substrat (2) selon le procédé de l'une quelconque des revendications précédentes, ledit appareil comprenant:

   un support de substrat (1) qui peut être soumis à un mouvement rotatif, ledit support de substrat (1) étant conçu pour supporter de façon amovible ledit substrat (2);
   au moins un système d'approvisionnement de liquide (5) pour appliquer un liquide sur au moins une partie de ladite surface dudit substrat (2);
   au moins un système d'approvisionnement de substance gazeuse (4) pour appliquer une substance gazeuse sur ladite surface dudit substrat (2);

dans lequel ledit système d'approvisionnement de substance gazeuse (4) et ledit système d'approvisionnement de liquide (5) sont positionnés de sorte que ladite substance gazeuse est appliquée plus près du centre dudit mouvement rotatif dudit support de substrat (1) que ledit liquide, **caractérisé en ce que** à la fois ledit système d'approvisionnement de liquide (5) et ledit système d'approvisionnement de substance gazeuse sont conçus pour bouger par rapport audit support de substrat (1) et lesdits systèmes sont conçus pour guider une frontière liquide-vapeur formée sur la surface et initialement localisée au centre de rotation dudit substrat vers l'extérieur depuis ledit centre vers le bord du substrat pour retirer de cette manière le liquide à partir de ladite surface dudit substrat.

15. Appareil selon la revendication 14, comprenant en outre une chambre dans laquelle ledit support de substrat est positionné, ladite chambre étant conçue pour éviter le retour par éclaboussure dudit liquide sur ladite surface dudit substrat.

16. Appareil selon la revendication 14, dans lequel ledit système d'approvisionnement de substance gazeuse (4) comprend au moins une buse (6) pour appliquer ladite substance gazeuse sur ladite surface dudit substrat et ledit système d'approvisionnement de liquide (5) comprend au moins une buse (6) pour appliquer ledit liquide sur ladite partie de ladite surface dudit substrat, lesdites buses (6) étant positionnées de sorte que ladite substance gazeuse est appliquée plus près du centre du mouvement rotatif du support de substrat que ledit liquide.

17. Appareil selon la revendication 16, dans lequel lesdites buses (6) sont montées sur et fixées à un bras (3), ledit bras étant mobile par rapport audit support de substrat (1).

18. Appareil selon la revendication 16, dans lequel lesdites buses (6) sont montées sur un bras fixe, lesdites buses étant mobiles.

FIG. 1

a)

10

12

2

2b

2b

3

11

b)

D

3

11

12

10

2

2

3

3

C

FIG. 2

FIG. 3a

FIG. 3b

10

2

4b — 4b

11

FIG. 4a

17

2

19

18

16

15

FIG. 4b

FIG. 5